# EUROPEAN PATENT APPLICATION

(11) **EP 4 489 546 A1**
(43) Date of publication of application: **08.01.2025**
(21) Application number: 23763662.6
(22) Date of filing: 22.02.2023
(51) Int. Cl.: H10K 50/805, H10K 50/844, H10K 59/131, H10K 71/00

(54) **DISPLAY DEVICE AND METHOD OF MANUFACTURING SAME**

(30) Priority: 04.03.2022 KR 20220027808
(71) Applicant: Samsung Display Co., Ltd., Gyeonggi-do 17113 (KR)
(72) Inventor: NAM, Yun Yong, Hwaseong-si Gyeonggi-do 18431 (KR); KIM, Eok Su, Seoul 06798 (KR); KIM, Hyung Jun, Seoul 04182 (KR); LIM, Jun Hyung, Seoul 06551 (KR); JEON, Kyung Jin, Incheon 21551 (KR)
(74) Representative: Marks & Clerk LLP
(86) International application number: PCT/KR2023/002547
(87) International publication number: WO 2023/167463

(57) **Abstract**

A display device includes a voltage line, a passivation layer disposed on the voltage line and having an undercut shape, a first connecting electrode disposed inside the undercut shape, a second connecting electrode electrically connecting the voltage line and the first connecting line, and a common electrode electrically connected to the voltage line through at least one of the first connecting electrode and the second connecting electrode.

## Description

### [Technical Field]

The present invention generally relates to a display device and a method of manufacturing the display device.

### [Background Art]

A display device includes light emitting diodes, and the light emitting diodes include a common electrode formed of a plate electrode. As the size of the display device increases, the size of the common electrode also increases. In addition, as the thickness of the display device decreases, the thickness of the common electrode also decreases. Accordingly, the need for a novel structure to prevent a voltage drop of the common voltage provided to the common electrode has increased.

### [Disclosure]

### [Technical Problem]

One object of the present invention is to provide a display device.

Another object of the present invention is to provide a method of manufacturing the display device.

However, the purpose of the present invention is not limited to these purposes, and may be expanded in various ways without departing from the spirit and scope of the present invention.

### [Technical Solution]

In order to achieve one object of the present invention described above, a display device according to an embodiment of the present invention includes a voltage line disposed on a substrate, a passivation layer disposed on the voltage line and having an undercut shape, a first connecting electrode disposed on the voltage line and disposed inside the undercut shape, a second connecting electrode disposed on the voltage line and electrically connecting the voltage line to the first connecting line, and a common electrode disposed on the second connecting electrode and electrically connected to the voltage line through at least one of the first connecting electrode and the second connecting electrode.

In an embodiment, the common electrode may overlap each of the first connecting electrode and the second connecting electrode and may contact each of the first connecting electrode and the second connecting electrode.

In an embodiment, the common electrode may not contact the voltage line.

In an embodiment, the first connecting electrode may contact the second connecting electrode.

In an embodiment, the second connecting electrode may contact the voltage line, the first connecting electrode, and the common electrode.

In an embodiment, the display device may further include an emission layer cut off by the undercut shape.

In an embodiment, the emission layer may be disposed between the second connecting electrode and the common electrode.

In an embodiment, the common electrode may cover a side surface of the emission layer.

In an embodiment, the display device may further include a data line disposed in a same layer as the voltage line, a first gate electrode disposed in a same layer as the first connecting electrode, a capping electrode disposed on the first gate electrode, and a pixel electrode disposed in a same layer as the second connecting electrode.

In order to achieve another object of the present invention described above, a method of manufacturing a display device according to an embodiment of the present invention includes steps of forming a voltage line on a substrate, forming a first connecting electrode and an etch electrode, on the voltage line, forming a preliminary passivation layer on the etch electrode to cover the etch electrode, patterning a passivation layer to expose a side surface of the etch electrode, removing the etch electrode so that the passivation layer has an undercut shape, forming a second connecting electrode electrically connecting the voltage line to the first connecting electrode, and forming a common electrode on the second connecting electrode, the common electrode is electrically connected to the voltage line through at least one of the first connecting electrode and the second connecting electrode.

In an embodiment, the etch electrode may react with a first etchant through the side surface which is exposed.

In an embodiment, the forming the second connecting electrode may be accomplished by forming a preliminary second connecting electrode and etching the preliminary second connecting electrode with a second etchant. The first etchant may include a same material as the second etchant.

In an embodiment, the etch electrode may include copper ("Cu"), and the preliminary second connecting electrode may include silver ("Ag") and indium tin oxide ("ITO").

In an embodiment, the first connecting electrode may include titanium ("Ti").

In an embodiment, the method may further include steps of forming a data line together with the voltage line, on the substrate, forming a first gate electrode together with the first connecting electrode, and forming a capping electrode on the first gate electrode. The passivation layer may expose an upper surface of the capping electrode.

In an embodiment, the etch electrode may react with a first etchant through the side surface which is exposed, the second connecting electrode may react with a second etchant, and the capping electrode may not react with the first etchant and the second etchant.

In an embodiment, the first gate electrode may include titanium, the etch electrode may include copper, and the capping electrode may include titanium.

In an embodiment, the first gate electrode may include titanium, the etch electrode may include copper, and the capping electrode may include indium tin oxide.

In an embodiment, the method may further include a step of forming an emission layer to be cut off by the undercut shape.

In an embodiment, a first angle at which the emission layer is deposited may be greater than a second angle at which the common electrode is deposited.

### [Advantageous Effects]

A display device according to embodiments of the present invention may include a voltage line, a first connecting electrode, a second connecting electrode, and the common electrode. The common electrode may be electrically connected to the voltage line through at least one of the first connecting electrode and the second connecting electrode. Accordingly, a voltage drop of the common voltage provided to the common electrode may be prevented.

In addition, an undercut shape in which the first connecting electrode is disposed may be formed in a passivation layer overlapping the voltage line. The undercut shape may cut off the emission layer so that the common electrode may be electrically connected to the voltage line. The undercut shape may be formed by removing an etch electrode, and the etch electrode may be etched with the same etchant for etching the pixel electrode. Accordingly, the economic efficiency of the process of forming the undercut shape may be improved.

However, the effects of the present invention are not limited to the above effects, and may be expanded in various ways without departing from the spirit and scope of the present invention.

### [Description of Drawings]

Figure 1 is a perspective view illustrating a display device according to an embodiment of the present invention.
Figure 2 is a block diagram illustrating the display device of Figure 1.
Figure 3 is a circuit diagram illustrating a pixel included in the display device of Figure 1.
Figure 4 is a perspective view illustrating a lower structure included in the display device of Figure 1.
Figure 5 is a cross-sectional view illustrating a lower structure included in the display device of Figure 1.
Figure 6 is a cross-sectional view illustrating an upper structure included in the display device of Figure 1.
Figures 7 to 18 are cross-sectional views illustrating a method of manufacturing the lower structure of Figure 5.
Figure 19 is a cross-sectional view illustrating a display device according to another embodiment of the present invention.
Figure 20 is an enlarged view of an area E of Figure 19.

### [Best Mode]

### [Mode for Invention]

Hereinafter, with reference to the attached drawings, embodiments of the present invention will be described in more detail. The same reference numerals will be used for the same components in the drawings, and duplicate descriptions of the same components will be omitted.

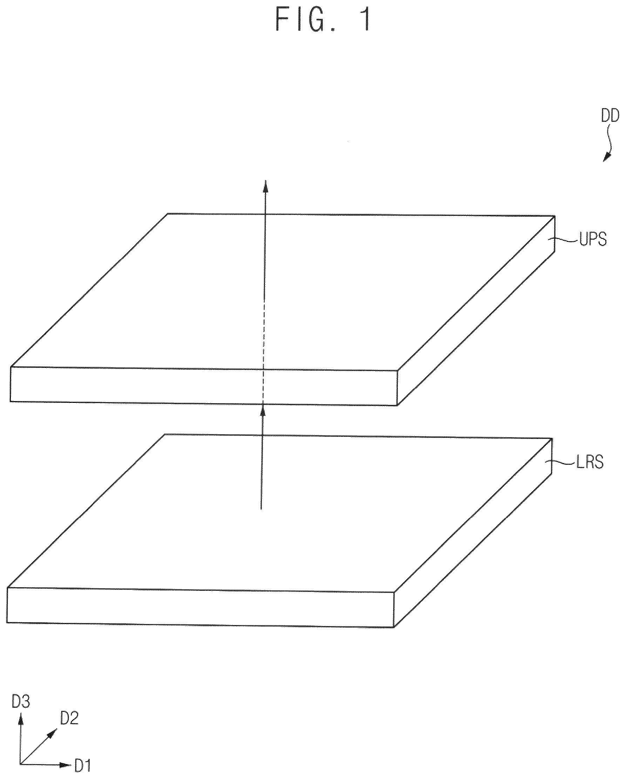

Figure 1 is a perspective view illustrating a display device according to an embodiment of the present invention.

Referring to Figure 1, a display device DD according to an embodiment may include a lower structure LRS and an upper structure UPS.

The lower structure LRS may include at least one light emitting diode, and may be referred to as an emission substrate. The lower structure LRS may emit light having a predetermined color.

The upper structure UPS may be disposed on the lower structure LRS. The upper structure UPS may include at least one color conversion pattern, and may be referred to as a color conversion substrate. The upper structure UPS may convert a color of light emitted from the lower structure LRS.

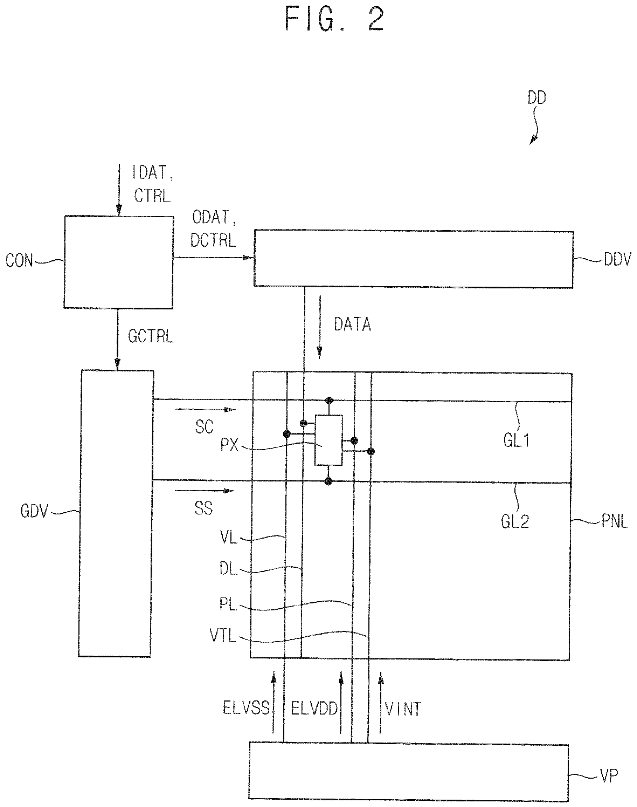

Figure 2 is a block diagram illustrating the display device of Figure 1.

Referring to Figure 2, the display device DD may include a display panel PNL, a data driver DDV, a gate driver GDV, a controller CON, and a voltage supply VP.

The pixel PX may receive a first gate signal SC through a first gate line GL1 and may receive a second gate signal SS through a second gate line GL2. In addition, the pixel PX may receive a data voltage DATA through a data line DL and may receive an initialization voltage VINT through an initialization voltage line VTL. The data voltage DATA may be written into the pixel PX in response to the first gate signal SC, and the initialization voltage VINT may be written into the pixel PX in response to the second gate signal SS.

The data driver DDV may generate the data voltage DATA based on an output image data ODAT and a data control signal DCTRL received from the controller CON. For example, the data driver DDV may generate the data voltage DATA corresponding to the output image data ODAT and may output the data voltage DATA in response to the data control signal DCTRL. The data control signal DCTRL may include an output data enable signal, a horizontal start signal, and a load signal.

The gate driver GDV may generate the first and second gate signals SC and SS based on a gate control signal GCTRL. For example, each of the first gate signal SC and the second gate signal SS may include a gate-on voltage for turning on the transistor and a gate-off voltage for turning off the transistor. The gate control signal GCTRL may include a vertical start signal, a clock signal, and the like.

The controller CON (e.g., a timing controller T-CON) may receive an input image data IDAT and a control signal CTRL from an external host processor (e.g., GPU). For example, the input image data IDAT may be RGB data including red image data, green image data, and blue image data. The control signal CTRL may include a vertical synchronization signal, a horizontal synchronization signal, an input data enable signal, a master clock signal, and the like. The controller CON may generate the gate control signal GCTRL, the data control signal DCTRL, and the output image data ODAT based on the input image data IDAT and the control signal CTRL.

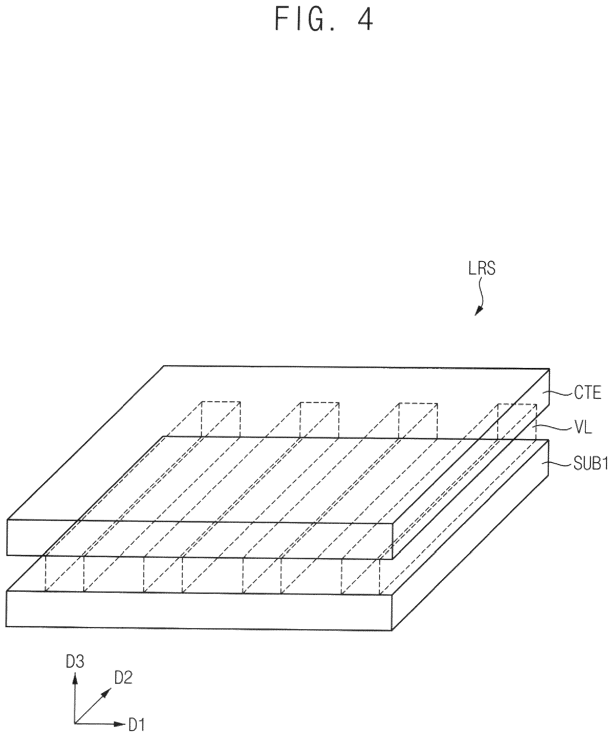

The voltage supply VP may provide a driving voltage ELVDD, a common voltage ELVSS, and the initialization voltage VINT to the pixel PX. The driving voltage ELVDD may be provided to the pixel PX through a driving line PL. The common voltage ELVSS may be provided to the pixel PX through a voltage line VL and a common electrode (e.g., a common electrode CTE of Figure 4).

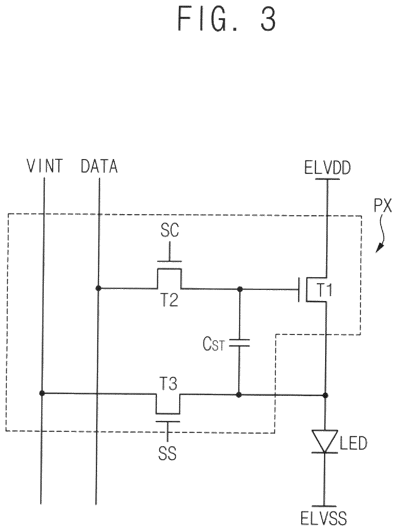

Figure 3 is a circuit diagram illustrating a pixel included in the display device of Figure 1.

Referring to Figure 3, the pixel PX may include a first transistor T1, a second transistor T2, a third transistor T3, and a storage capacitor CST. The pixel PX may be electrically connected to the light emitting diode LED.

The first transistor T1 may include a first terminal, a second terminal, and a gate terminal. The first terminal may receive the driving voltage ELVDD. The second terminal may be connected to the light emitting diode LED. The gate terminal disposed between the first and second terminals may be connected to the second transistor T2. The first transistor T1 may generate a driving current based on the driving voltage ELVDD and the data voltage DATA.

The second transistor T2 may include a first terminal, a second terminal, and a gate terminal. The first terminal may receive the data voltage DATA. The second terminal may be connected to the first transistor T1. The gate terminal disposed between the first and second terminals may receive the first gate signal SC. The second transistor T2 may transmit the data voltage DATA in response to the first gate signal SC.

The third transistor T3 may include a first terminal, a second terminal, and a gate terminal. The first terminal may be connected to the first transistor T1. The second terminal may receive the initialization voltage VINT. The gate terminal disposed between the first and second terminals may receive the second gate signal SS. The third transistor T3 may transmit the initialization voltage VINT in response to the second gate signal SS.

The storage capacitor CST may include a first terminal and a second terminal. The first terminal may be connected to the gate terminal of the first transistor T1 and the second terminal of the second transistor T2. The second terminal may be connected to the first terminal of the third transistor T3 and the second terminal of the first transistor T1 and the light emitting diode LED. The storage capacitor CST may maintain the voltage level of the gate terminal of the first transistor T1 during the inactivation period of the first gate signal SC.

The light emitting diode LED may include a first terminal and a second terminal. The first terminal may be connected to the second terminal of the first transistor T 1. The second terminal may receive the common voltage ELVSS. The light emitting diode LED may emit light having a luminance corresponding to the driving current. The light emitting diode LED may include an organic light emitting diode using an organic material as an emission layer, an inorganic light emitting diode using an inorganic material as an emission layer, and the like.

Figure 4 is a perspective view illustrating a lower structure included in the display device of Figure 1.

Referring to Figure 4, the lower structure LRS included in the display device DD may include a substrate SUB1, the voltage line VL, and the common electrode CTE.

The substrate SUB1 may be parallel to a plane formed in a first direction D1 (e.g., X-direction) and a second direction D2 (e.g., Y-direction) intersecting the first direction D1, and may have a thickness in a third direction D3 (e.g., Z-direction) perpendicular to the plane.

The substrate SUB1 may include a transparent or opaque material. Examples of the material that can be used as the substrate SUB1 may include glass, quartz, plastic, or the like. These may be used alone or in combination with each other.

The voltage line VL may be disposed on the substrate SUB1. In an embodiment, the voltage line VL may extend in the second direction D2 and may be spaced apart from each other in the first direction D1. The voltage line VL may transfer the common voltage ELVSS to the common electrode CTE. The voltage line VL may prevent a voltage drop of the common voltage ELVSS.

In another embodiment, the voltage line VL may extend in the first direction D1 and may be spaced apart from each other in the second direction D2. In still another embodiment, the voltage line VL may include a first voltage line and a second voltage line disposed on the first voltage line. The first and second voltage lines may cross each other.

The common electrode CTE may be disposed on the voltage line VL. In an embodiment, the common electrode CTE may be formed of a plate electrode. The common electrode CTE may receive the common voltage ELVSS from the voltage line VL. For example, the common electrode CTE may correspond to the second terminal of the light emitting diode LED described with reference to Figure 3.

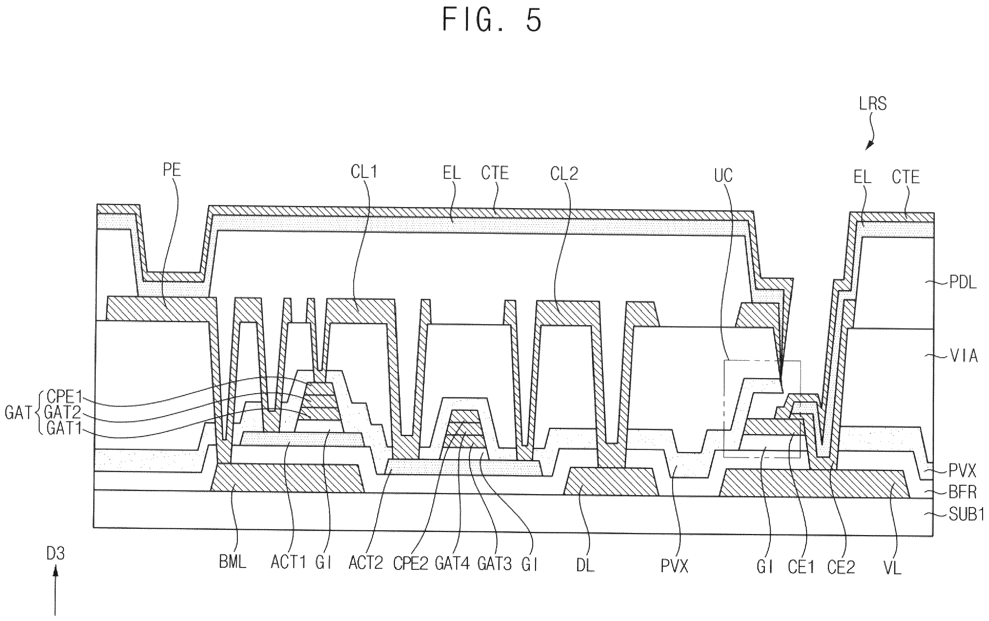

Figure 5 is a cross-sectional view illustrating a lower structure included in the display device of Figure 1.

Referring to Figure 5, the lower structure LRS may include the substrate SUB1, a lower electrode BML, the data line DL, a buffer layer BFR, a first active pattern ACT1, a second active pattern ACT2, a gate insulating pattern GI, a first gate electrode GAT1, a second gate electrode GAT2, a first capping electrode CPE1, a third gate electrode GAT3, a fourth gate electrode GAT4, a second capping electrode CPE2, a first connecting electrode CE1, a passivation layer PVX, a via insulating layer VIA, a pixel electrode PE, a first connecting line CL1, a second connecting line CL2 , a second connecting electrode CE2, a pixel defining layer PDL, an emission layer EL, and the common electrode CTE.

In an embodiment, the lower electrode BML, the data line DL, and the voltage line VL may be disposed on the substrate SUB 1. For example, the lower electrode BML, the data line DL, and the voltage line VL may be formed together with each other. In other words, the lower electrode BML, the data line DL, and the voltage line VL may be disposed in the same layer.

In an embodiment, the lower electrode BML, the data line DL, and the voltage line VL may be formed of a metal, an alloy, a conductive metal oxide, a transparent conductive material, or the like. Examples of materials that may be used as the lower electrode BML, the data line DL, and the voltage line VL may include silver ("Ag"), an alloy containing silver, molybdenum ('Mo"), an alloy containing molybdenum, aluminium ("Al"), an alloy containing aluminium, aluminium nitride ("AlN"), tungsten ("W"), tungsten nitride ("WN"), copper ("Cu"), nickel ("Ni"), chromium ("Cr"), chromium nitride ("CrN"), titanium ("Ti"), tantalum ("Ta"), platinum ("Pt"), scandium ("Sc"), indium tin oxide ("ITO"), indium zinc oxide ("IZO"), or the like. These may be used alone or in combination with each other. In addition, each of the lower electrode BML, the data line DL, and the voltage line VL may be formed of a single layer or a multilayer.

In an embodiment, the driving voltage ELVDD may be provided to the lower electrode BML, the data voltage DATA may be provided to the data line DL, and the common voltage ELVSS may be provided to the voltage line VL.

The buffer layer BFR may be disposed on the lower electrode BML, the data line DL, and the voltage line VL. In an embodiment, the buffer layer BFR may be formed of an insulating material. Examples of the insulating material that can be used as the buffer layer BFR may include silicon oxide, silicon nitride, silicon oxynitride, and the like. These may be used alone or in combination with each other. In addition, the buffer layer BFR may be formed of a single layer or a multilayer.

The first active pattern ACT1 and the second active pattern ACT2 may be disposed on the buffer layer BFR. For example, the first active pattern ACT1 and the second active pattern ACT2 may be formed together with each other.

In an embodiment, the first active pattern ACT1 and the second active pattern ACT2 may be formed of a silicon semiconductor material or an oxide semiconductor material. Examples of the silicon semiconductor material that may be used as the first active pattern ACT1 and the second active pattern ACT2 may include amorphous silicon and polycrystalline silicon. Examples of the oxide semiconductor material that may be used as the first active pattern ACT1 and the second active pattern ACT2 may include IGZO (InGaZnO) and ITZO (InSnZnO). In addition, the oxide semiconductor material may further include indium ("In"), gallium ("Ga"), tin ("Sn"), zirconium ("Zr"), vanadium ("V"), hafnium ("Hf"), cadmium ("Cd"), germanium ("Ge"), chromium ("Cr"), titanium ("Ti"), and zinc ("Zn"). These may be used alone or in combination with each other.

In an embodiment, the first active pattern ACT1 may be disposed on and overlap the lower electrode BML and may be electrically connected to the lower electrode BML by the first connecting line CL1. For example, the first active pattern ACT1 may correspond to the first terminal and the second terminal of the first transistor T 1.

In an embodiment, the second active pattern ACT2 may be electrically connected to the data line DL by the second connecting line CL2. For example, the second active pattern ACT2 may correspond to the first terminal and the second terminal of the second transistor T2.

The gate insulating pattern GI may be directly disposed on the first active pattern ACT1, the second active pattern ACT2, and the buffer layer BFR. In an embodiment, the gate insulating pattern GI may be formed of an insulating material. Examples of the insulating material that can be used as the gate insulating pattern GI may include silicon oxide, silicon nitride, silicon oxynitride, and the like. These may be used alone or in combination with each other. In addition, the gate insulating pattern GI may be formed of a single layer or a multilayer.

Each of the first gate electrode GAT1, the third gate electrode GAT3, and the first connecting electrode CE1 may be disposed on the gate insulating pattern GI. For example, the first gate electrode GAT1, the third gate electrode GAT3, and the first connecting electrode CE1 may be formed together with each other. In other words, the first gate electrode GAT1, the third gate electrode GAT3, and the first connecting electrode CE1 may be disposed in a same layer.

In an embodiment, each of the first gate electrode GAT1, the third gate electrode GAT3, and the first connecting electrode CE1 may be formed of a metal, an alloy, a conductive metal oxide, a transparent conductive material, or the like. Examples of materials that can be used as the first gate electrode GAT1, the third gate electrode GAT3, and the first connecting electrode CE1 may include silver ("Ag"), an alloy containing silver, molybdenum ("Mo"), an alloy containing molybdenum, aluminium ("Al"), an alloy containing aluminium, aluminium nitride ("AlN"), tungsten ("W"), tungsten nitride ("WN"), copper ("Cu"), nickel ("Ni"), chromium ("Cr"), chromium nitride ("CrN"), titanium ("Ti"), tantalum ("Ta"), platinum ("Pt"), scandium ("Sc"), indium tin oxide ("ITO"), indium zinc oxide ("IZO"), or the like. For example, the first gate electrode GAT1, the third gate electrode GAT3, and the first connecting electrode CE1 may be formed of titanium ("Ti").

The first gate electrode GAT1 may overlap the lower electrode BML and the first active pattern ACT1. The third gate electrode GAT3 may overlap the second active pattern ACT2.

The first connecting electrode CE1 may be electrically connected to the voltage line VL. In another embodiment, the first connecting electrode CE1 may overlap the voltage line VL and may not contact the voltage line VL. In still another embodiment, the first connecting electrode CE1 may not overlap the voltage line VL.

The second gate electrode GAT2 may be disposed on the first gate electrode GAT1, and the fourth gate electrode GAT4 may be disposed on the third gate electrode GAT3. For example, the second gate electrode GAT2 and the fourth gate electrode GAT4 may be formed together with each other. In other words, the second gate electrode GAT2 and the fourth gate electrode GAT4 may be disposed in the same layer.

In an embodiment, the second gate electrode GAT2 and the fourth gate electrode GAT4 may be formed of a metal, an alloy, a conductive metal oxide, a transparent conductive material, or the like. Examples of materials that can be used as the second gate electrode GAT2 and the fourth gate electrode GAT4 may include silver ("Ag"), an alloy containing silver, molybdenum ("Mo"), an alloy containing molybdenum, aluminium ("Al"), an alloy containing aluminium, aluminium nitride ("AlN"), tungsten ("W"), tungsten nitride ("WN"), copper ("Cu"), nickel ("Ni"), chromium ("Cr"), chromium nitride ("CrN"), titanium ("Ti"), tantalum ("Ta"), platinum ("Pt"), scandium ("Sc"), indium tin oxide ("ITO"), indium zinc oxide ("IZO"), or the like. For example, the second gate electrode GAT2 and the fourth gate electrode GAT4 may be formed of copper ("Cu").

The first capping electrode CPE1 may be disposed on the second gate electrode GAT2, and the second capping electrode CPE2 may be disposed on the fourth gate electrode GAT4. For example, the first capping electrode CPE1 and the second capping electrode CPE2 may be formed together with each other. In other words, the first capping electrode CPE1 and the second capping electrode CPE2 may be disposed in the same layer.

In an embodiment, the first capping electrode CPE1 and the second capping electrode CPE2 may be formed of a metal, an alloy, a conductive metal oxide, a transparent conductive material, or the like. Examples of materials that can be used as the first capping electrode CPE1 and the second capping electrode CPE2 may include silver ("Ag"), an alloy containing silver, molybdenum ("Mo"), an alloy containing molybdenum, aluminium ("Al"), an alloy containing aluminium, aluminium nitride ("AlN"), tungsten ("W"), tungsten nitride ("WN"), copper ("Cu"), nickel ("Ni"), chromium ("Cr"), chromium nitride ("CrN"), titanium ("Ti"), tantalum ("Ta"), platinum ("Pt"), scandium ("Sc"), indium tin oxide ("ITO"), indium zinc oxide ("IZO"), or the like.

In an embodiment, each of the first capping electrode CPE1 and the second capping electrode CPE2 may have a Ti/Cu structure. In another embodiment, each of the first capping electrode CPE1 and the second capping electrode CPE2 may be formed of indium tin oxide (ITO).

The first capping electrode CPE1 may overlap the lower electrode BML and the first active pattern ACT1, and may contact the second gate electrode GAT2. The second capping electrode CPE2 may overlap the second active pattern ACT2 and may contact the fourth gate electrode GAT4.

In an embodiment, the first gate electrode GAT1, the second gate electrode GAT2, and the first capping electrode CPE1 may constitute a gate electrode GAT. In other words, the gate electrode GAT may have a multilayer structure.

The passivation layer PVX may be disposed on the buffer layer BFR. The passivation layer PVX may cover the first gate electrode GAT1, the second gate electrode GAT2, and the first capping electrode CPE1, and may cover the third gate electrode GAT3, the fourth gate electrode GAT4, and the second capping electrode CPE2.

In an embodiment, the passivation layer PVX may have an undercut shape UC overlapping the first connecting electrode CE1. In other words, the undercut shape UC may be formed in the passivation layer PVX, and the first connecting electrode CE1 may be disposed inside the undercut shape UC. Accordingly, an upper surface of the first connecting electrode CE1 and the passivation layer PVX may not contact each other. In addition, although not shown, an organic material may be filled between the upper surface of the first connecting electrode CE1 and the passivation layer PVX.

In an embodiment, the passivation layer PVX may be formed of an insulating material. Examples of the insulating material that can be used as the passivation layer PVX may include silicon oxide, silicon nitride, silicon oxynitride, and the like. These may be used alone or in combination with each other. In addition, the passivation layer PVX may be formed of a single layer or a multilayer.

The via insulating layer VIA may be disposed on the passivation layer PVX. In an embodiment, the via insulating layer VIA may be formed of an insulating material. Examples of the insulating material that may be used as the via insulating layer VIA may include photoresist, polyacrylic resin, polyimide resin, acrylic resin, and the like. These may be used alone or in combination with each other.

The pixel electrode PE, the first connecting line CL1, and the second connecting line CL2 may be disposed on the via insulating layer VIA. The second connecting electrode CE2 may be disposed on the via insulating layer VIA and may be cut off by the undercut shape UC. For example, the pixel electrode PE, the first connecting line CL1, the second connecting line CL2, and the second connecting electrode CE2 may be formed together with each other.

In an embodiment, the pixel electrode PE, the first connecting line CL1, the second connecting line CL2, and the second connecting electrode CE2 may include a metal, an alloy, a conductive metal oxide, and a transparent conductive material. Examples of materials that may be used as the pixel electrode PE, the first connecting line CL1, the second connecting line CL2, and the second connecting electrode CE2 may include silver ("Ag"), an alloy containing silver, molybdenum ("Mo"), an alloy containing molybdenum, aluminium ("Al"), an alloy containing aluminium, aluminium nitride ("AIN"), tungsten ("W"), tungsten nitride ("WN"), copper ("Cu"), nickel ("Ni"), chromium ("Cr"), chromium nitride ("CrN"), titanium ("Ti"), tantalum ("Ta"), platinum ("Pt"), scandium ("Sc"), indium tin oxide ("ITO"), indium zinc oxide ("IZO") etc. For example, each of the pixel electrode PE, the first connecting line CL1, the second connecting line CL2, and the second connecting electrode CE2 may have an ITO/Ag/ITO structure.

In an embodiment, the pixel electrode PE may contact the lower electrode BML and the first active pattern ACT 1. The pixel electrode PE may electrically connect the lower electrode BML through a first contact hole penetrating the passivation layer PVX and the buffer layer BFR and the first active pattern ACT1 through a second contact hole penetrating the passivation layer PVX. In addition, the pixel electrode PE may correspond to the first terminal of the light emitting diode LED.

In an embodiment, the first connecting line CL1 may contact the first capping electrode CPE1 and the second active pattern ACT2. The first connecting line CL1 may electrically connect the first capping electrode CPE1 and the second active pattern ACT2 to each other.

In an embodiment, the second connecting line CL2 may contact the data line DL and the second active pattern ACT2 through contact holes penetrating the passivation layer PVX. The second connecting line CL2 may electrically connect the data line DL through a third contact hole penetrating the passivation layer PVX and the buffer layer BFR to the second active pattern ACT2 through a fourth contact hole penetrating the passivation layer PVX.

In an embodiment, the second connecting electrode CE2 may be cut off by the undercut shape UC. In addition, the second connecting electrode CE2 may contact the voltage line VL and the first connecting electrode CE1. Accordingly, the second connecting electrode CE2 may electrically connect the voltage line VL and the first connecting electrode CE1.

The pixel defining layer PDL may be disposed on the via insulating layer VIA. In an embodiment, the pixel defining layer PDL may be formed of an insulating material. Examples of the insulating material that can be used as the pixel defining layer PDL may include photoresist, polyacrylic resin, polyimide resin, acrylic resin, and the like. These may be used alone or in combination with each other. In an embodiment, a first opening exposing an upper surface of the pixel electrode PE and a second opening overlapping the second connecting electrode CE2 may be formed in the pixel defining layer PDL.

The emission layer EL may be disposed on the pixel electrode PE, the pixel defining layer PDL, and the second connecting electrode CE2. In other words, the emission layer EL may be formed on the entire surface of the lower structure LRS. In addition, in an embodiment, the emission layer EL may be cut off by the undercut shape UC.

The common electrode CTE may be disposed on the emission layer EL. In an embodiment, the common electrode CTE may be formed of a metal, an alloy, a conductive metal oxide, a transparent conductive material, or the like. Examples of the material that can be used as the common electrode CTE may include silver ("Ag"), an alloy containing silver, molybdenum ("Mo"), an alloy containing molybdenum, aluminium ("Al"), an alloy containing aluminium, aluminium nitride ("AlN"), tungsten ("W"), tungsten nitride ("WN"), copper ("Cu"), nickel ("Ni"), chromium ("Cr"), chromium nitride ("CrN"), titanium ("Ti"), tantalum ("Ta"), platinum ("Pt"), scandium ("Sc"), indium tin oxide ("ITO"), indium zinc oxide ("IZO"), and the like. These may be used alone or in combination with each other. In addition, the common electrode CTE may be formed of a single layer or a multilayer.

In an embodiment, the common electrode CTE may be cut off by the undercut shape UC. Accordingly, the emission layer EL may be disposed between the second connecting electrode CE2 and the common electrode CTE. In addition, in an embodiment, the common electrode CTE may cover a side surface of the emission layer EL.

In an embodiment, the first connecting electrode CE1, the second connecting electrode CE2, and the common electrode CTE may be formed inside the undercut shape UC. In addition, the common electrode CTE may contact the first connecting electrode CE1 and the second connecting electrode CE2. Accordingly, the common electrode CTE may be electrically connected to the voltage line VL. In this case, the common electrode CTE may not directly contact the voltage line VL.

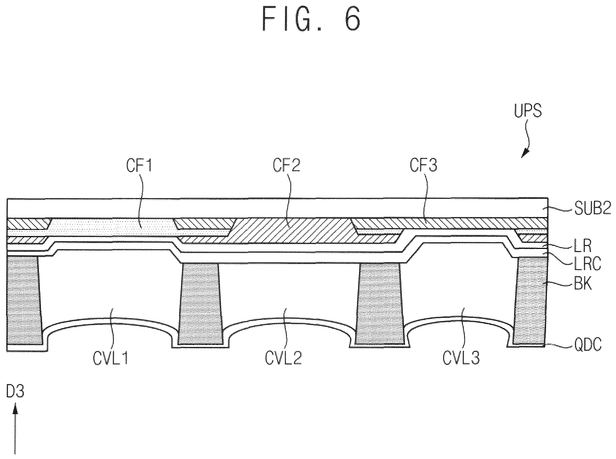

Figure 6 is a cross-sectional view illustrating an upper structure included in the display device of Figure 1.

Referring to Figure 6, the upper structure UPS may include an upper substrate SUB2, a first color filter CF1, a second color filter CF2, a third color filter CF3, a refractive layer LR, a refractive capping layer LRC, a bank layer BK, a first color conversion pattern CVL1, a second color conversion pattern CVL2, a third color conversion pattern CVL3, and a color conversion capping layer QDC.

The upper substrate SUB2 may include a transparent or opaque material. Examples of the material that can be used as the upper substrate SUB2 may include glass, quartz, plastic, or the like. These may be used alone or in combination with each other.

The first color filter CF1, the second color filter CF2, and the third color filter CF3 may be disposed under the upper substrate SUB2. In an embodiment, the first color filter CF1 may transmit light having a wavelength corresponding to red light, the second color filter CF2 may transmit light having a wavelength corresponding to green light, and the third color filter CF3 may transmit light having a wavelength corresponding to blue light. An overlapped area between the first color filter CF1, the second color filter CF2, and the third color filter CF3 may function as a light blocking layer.

The refractive layer LR may be disposed under the first to third color filters CF1, CF2, and CF3. The refractive layer LR may have a predetermined refractive index. Accordingly, the light efficiency of the display device DD may be improved. In another embodiment, the refractive layer LR may be disposed under the first to third color conversion patterns CVL1, CVL2, and CVL3. In still another embodiment, the refractive layer LR may include first and second refractive layers, the first refractive layer may be disposed on the first to third color conversion patterns CVL1, CVL2, and CVL3, and the second refractive layer may be disposed under the first to third color conversion patterns CVL1, CVL2, and CVL3.

The refractive capping layer LRC may be disposed under the refractive layer LR. The refractive capping layer LRC may protect the refractive layer LR. In another embodiment, a refractive capping layer may be disposed on the refractive layer LR. In still another embodiment, a first refractive capping layer may be disposed under the refractive layer LR, and a refractive second capping layer may be disposed on the refractive layer LR.

The bank layer BK may be disposed under the refractive capping layer LRC. The bank layer BK may be formed of a light blocking material and may block light emitted from the lower portion. In addition, an opening exposing the refractive capping layer LRC may be formed in the bank layer BK.

The first color conversion pattern CVL1 may be disposed under the first color filter CF1 and may overlap a first pixel electrode. The first color conversion pattern CVL1 may convert a wavelength of light emitted from the emission layer EL. For example, the first color conversion pattern CVL1 may include a phosphor, a scatterer, or quantum dots. As the light emitted from the emission layer EL passes through the first color conversion pattern CVL1, red light may be emitted.

The second color conversion pattern CVL2 may be disposed under the second color filter CF2 and may overlap a second pixel electrode. The second color conversion pattern CVL2 may convert a wavelength of light emitted from the emission layer EL. For example, the second color conversion pattern CVL2 may include a phosphor, a scatterer, or quantum dots. As light emitted from the emission layer EL passes through the second color conversion pattern CVL2, green light may be emitted.

The third color conversion pattern CVL3 may be disposed under the third color filter CF3 and may overlap a third pixel electrode. The third color conversion pattern CVL3 may scatter a wavelength of light emitted from the emission layer EL. For example, the third color conversion pattern CVL3 may include a phosphor, a scatterer, or quantum dots. As the light emitted from the emission layer EL passes through the third color conversion pattern CVL3, blue light may be emitted.

In an embodiment, each of the first to third color conversion patterns CVL1, CVL2, and CVL3 may have a concave cross-sectional shape.

The color conversion capping layer QDC may be disposed under the first to third color conversion patterns CVL1, CVL2, and CVL3. The color conversion capping layer QDC may protect the first to third color conversion patterns CVL1, CVL2, and CVL3.

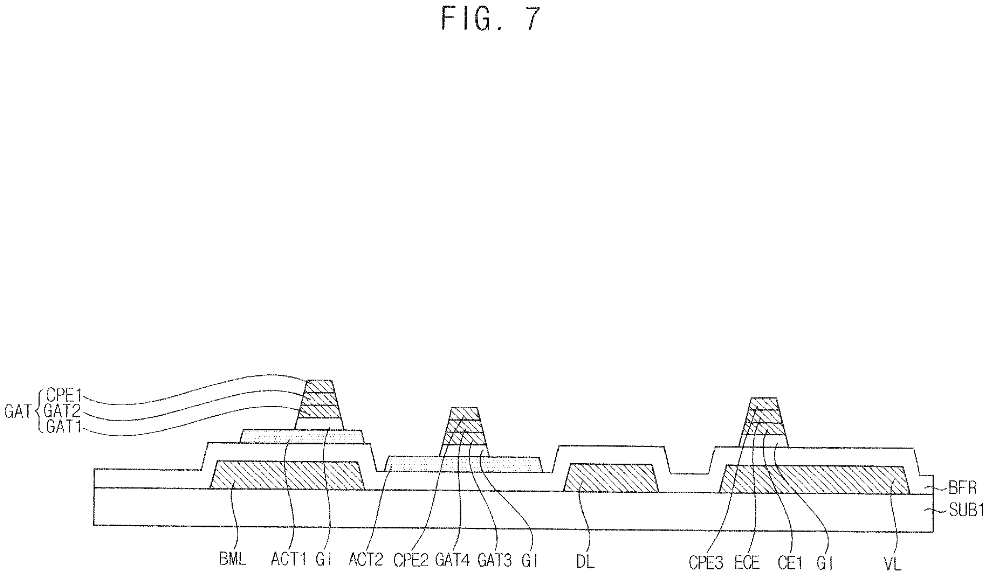

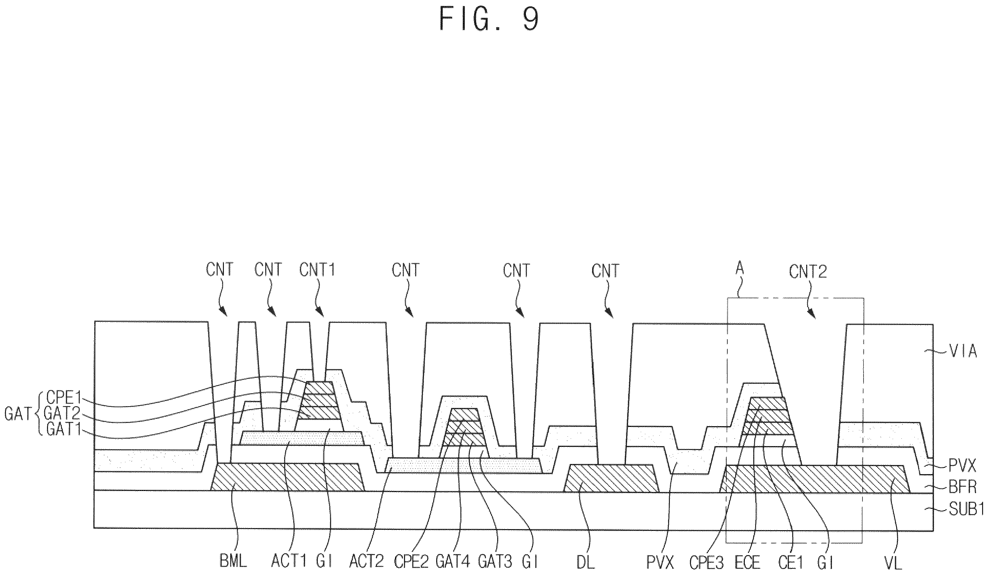

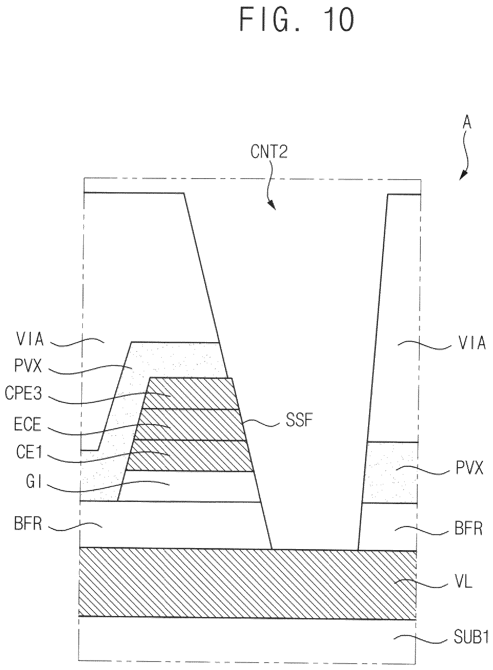

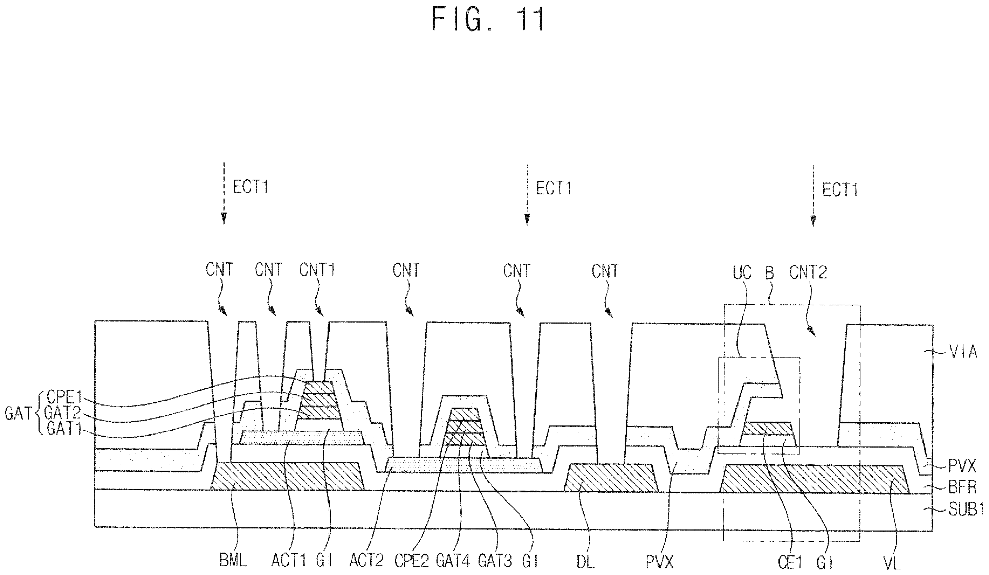

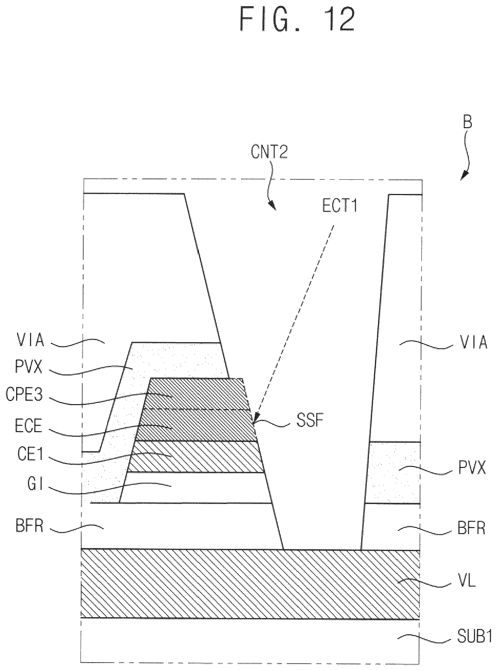

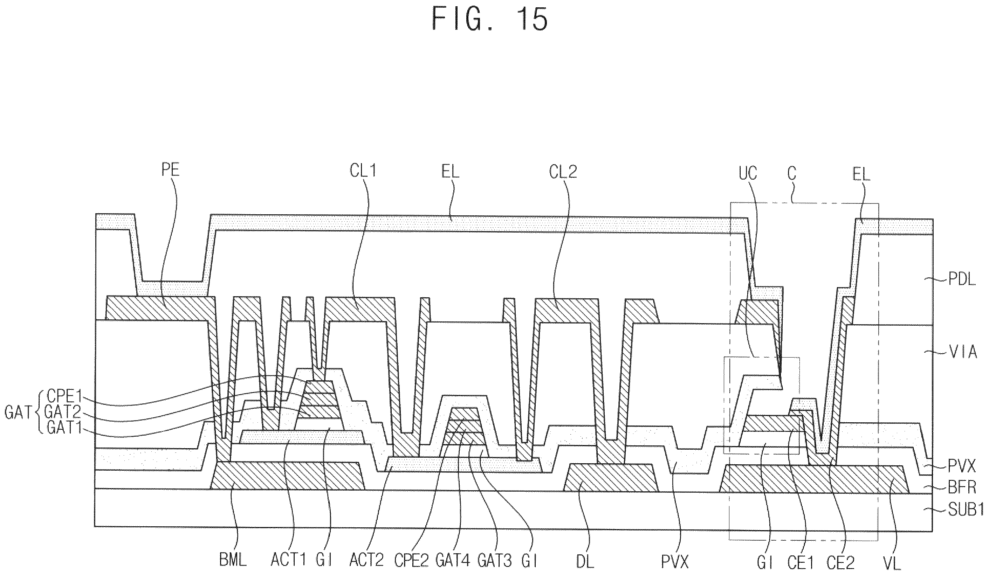

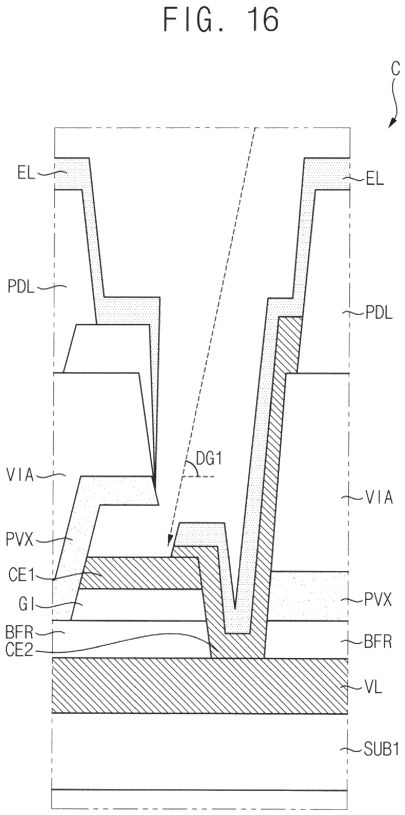

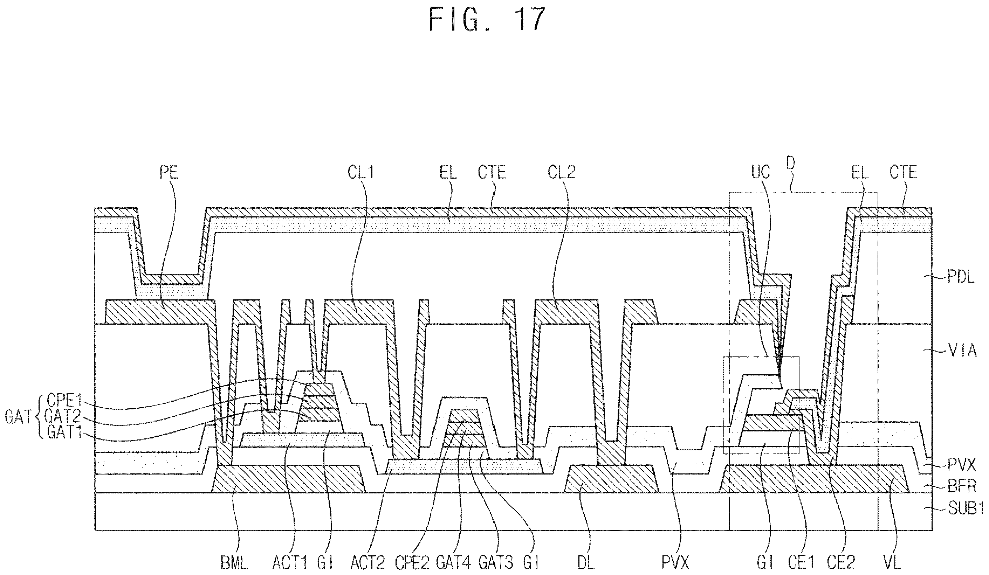

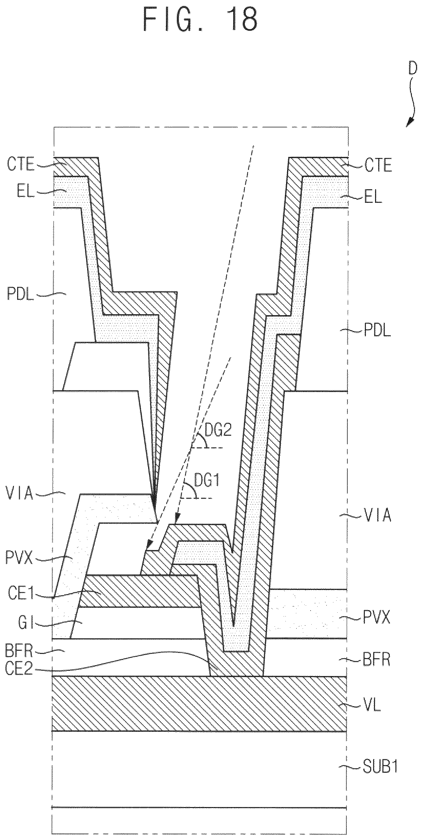

Figures 7 to 18 are cross-sectional views illustrating a method of manufacturing the lower structure of Figure 5. For example, Figure 10 is an enlarged view of area A of Figure 9, Figure 12 is an enlarged view of area B of Figure 11, Figure 16 is an enlarged view of area C of Figure 15, and Figure 18 is an enlarged view of area D of Figure 17.

Referring to Figure 7, the lower electrode BML, the data line DL, and the voltage line VL may be formed on the substrate SUB1. The buffer layer BFR may be formed to cover the lower electrode BML, the data line DL, and the voltage line VL. The first active pattern ACT1 and the second active pattern ACT2 may be formed on the buffer layer BFR.

A gate insulating layer may be formed on the first active pattern ACT1 and the second active pattern ACT2, and a gate electrode layer may be formed on the gate insulating layer. Then, the first gate electrode GAT1, the second gate electrode GAT2, the first capping electrode CPE1, the third gate electrode GAT3, the fourth gate electrode GAT4, the second capping electrode CPE2, the first connecting electrode CE1, an etch electrode ECE, and a third capping electrode CPE3 can be formed by patterning the gate insulating layer and the gate electrode layer together, the gate insulating pattern GI.

In detail, the first gate electrode GAT1, the third gate electrode GAT3, and the first connecting electrode CE1 may be formed of the same material. In an embodiment, the first gate electrode GAT1, the third gate electrode GAT3, and the first connecting electrode CE1 may be formed of titanium ("Ti").

The second gate electrode GAT2, the fourth gate electrode GAT4, and the etch electrode ECE may be formed together of the same material. In an embodiment, the second gate electrode GAT2, the fourth gate electrode GAT4, and the etch electrode ECE may be formed of copper ("Cu").

The first capping electrode CPE1, the second capping electrode CPE2, and the third capping electrode CPE3 may be formed of the same material. In an embodiment, each of the first capping electrode CPE1, the second capping electrode CPE2, and the third capping electrode CPE3 may have a Ti/Cu structure. In another embodiment, each of the first capping electrode CPE1, the second capping electrode CPE2, and the third capping electrode CPE3 may be formed of ITO.

However, a metal forming the first gate electrode GAT1, the second gate electrode GAT2, the first capping electrode CPE1, the third gate electrode GAT3, the fourth gate electrode GAT4, the second capping electrode CPE2, the first connecting electrode CE1, the etch electrode ECE, and the third capping electrode CPE3 is not limited thereto. The metal may be variously selected in consideration of hardness, electrical conductivity, etch selectivity, and the like.

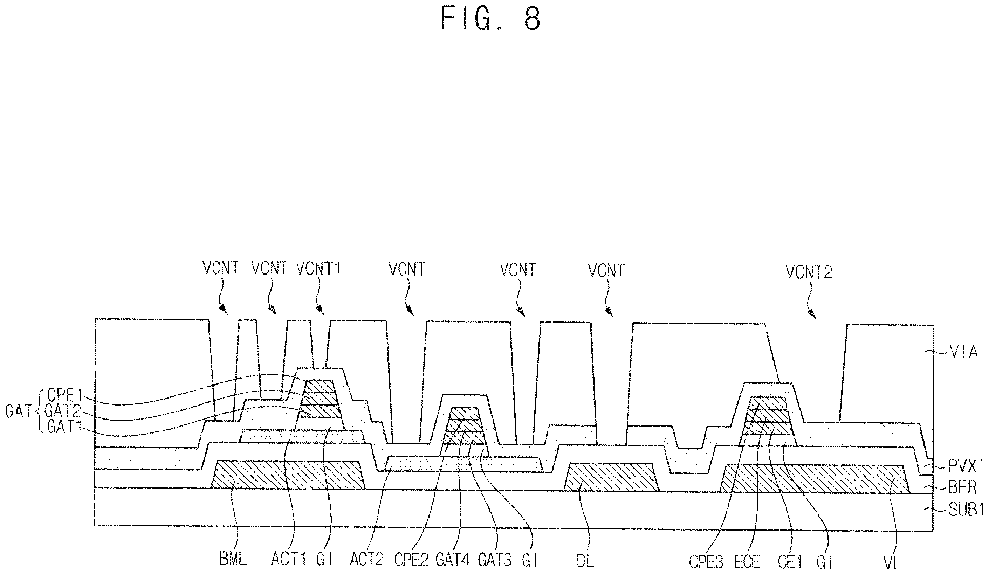

Referring to Figure 8, a preliminary passivation layer PVX' may be formed on the buffer layer BFR. The preliminary passivation layer PVX' may cover the first gate electrode GAT1, the second gate electrode GAT2, and the first capping electrode CPE1, may cover the third gate electrode GAT3, the fourth gate electrode GAT4, and the second capping electrode CPE2, and may cover the first connecting electrode CE1, the etch electrode ECE, and the third capping electrode CPE3.

The via insulating layer VIA may be disposed on the preliminary passivation layer PVX'. Via contact holes VCNT may be formed in the via insulating layer VIA. The via contact holes VCNT may pass through the via insulating layer VIA. In an embodiment, the via contact holes VCNT may include a first via contact hole VCNT1 overlapping the first capping electrode CPE1 and a second via contact hole VCNT2 overlapping the third capping electrode CPE3. The first via contact hole VCNT1 may expose the preliminary passivation layer PVX' overlapping the first capping electrode CPE1, and the second via contact hole VCNT2 may expose the preliminary passivation layer PVX' overlapping the third capping electrode CPE3.

Referring to Figures 9 and 10, contact holes CNT may be formed in the preliminary passivation layer PVX'. The contact holes CNT may pass through the preliminary passivation layer PVX', and thus the passivation layer PVX may be formed. The contact holes CNT may include a first contact hole CNT1 connected to the first via contact hole VCNT1 and a second contact hole CNT2 connected to the second via contact hole VNCT2. The first contact hole CNT1 may expose the first capping electrode CPE1. As shown in Figure 10, the second contact hole CNT2 may expose a side surface SSF of the etch electrode ECE and an upper surface of the voltage line VL.

Referring to Figures 11 and 12, the etch electrode ECE and the third capping electrode CPE3 may be removed. In an embodiment, the etch electrode ECE and the third capping electrode CPE3 may be removed by reacting with the first etchant ECT1. Accordingly, the undercut shape UC may be formed in the passivation layer PVX. In addition, the first connecting electrode CE1 may be disposed inside the undercut shape UC.

In detail, as shown in Figure 12, the first etchant ECT1 may contact the side surface SSF, which is exposed, of the etch electrode ECE. In other words, the etch electrode ECE may react with the first etchant ECT1 through the side surface SSF which is exposed. Accordingly, the etch electrode ECE may be etched and removed. In addition, the third capping electrode CPE3 may be removed together with the etch electrode ECE.

Meanwhile, as shown in Figure 11, the first etchant ECT1 may contact the upper surface of the first capping electrode CPE1. In this case, the first capping electrode CPE1 may be a metal that does not react with the first etchant ECT1. Accordingly, the first capping electrode ECP1 may protect the second gate electrode GAT2 so that the second gate electrode GAT2 is not removed from the first etchant ECT1.

In other words, the first etchant ECT1 may be an etchant that does not react with the first capping electrode CPE1, and the third capping electrode CPE3 and may react with the etching electrode ECE.

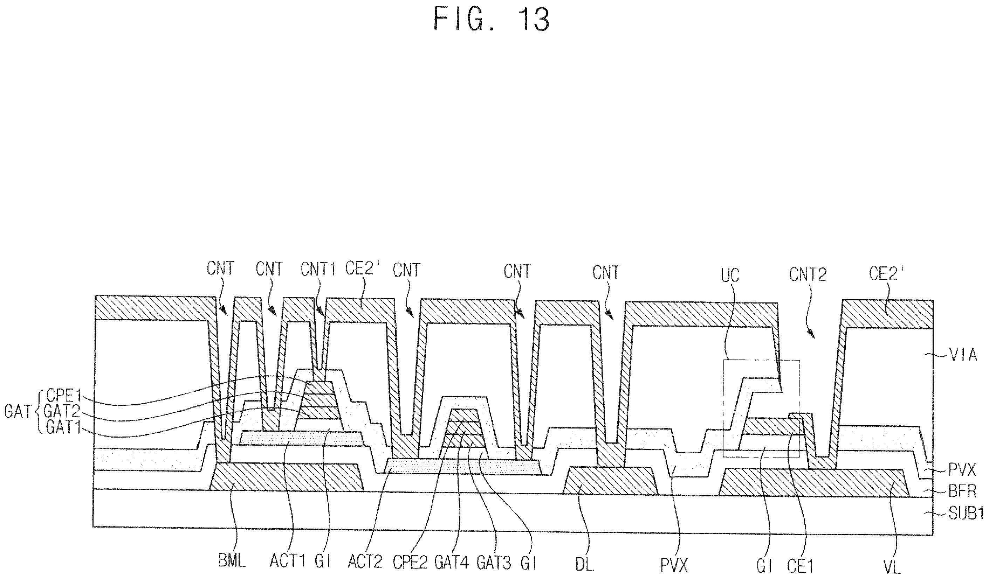

Referring to Figure 13, a preliminary second connecting electrode CE2' may be formed on the via insulating layer VIA. The preliminary second connecting electrode CE2' may be formed on the entire surface of the lower structure LRS. The preliminary second connecting electrode CE2' may contact the first capping electrode CPE1 through the first contact hole CNT1 and may contact the first connecting electrode CE1 and the voltage line VL through the second contact hole CNT2. In addition, the preliminary second connecting electrode CE2' may be connected to the lower electrode BML, the first active pattern ACT1, the second active pattern ACT2 and the data line DL through the contact holes CNT.

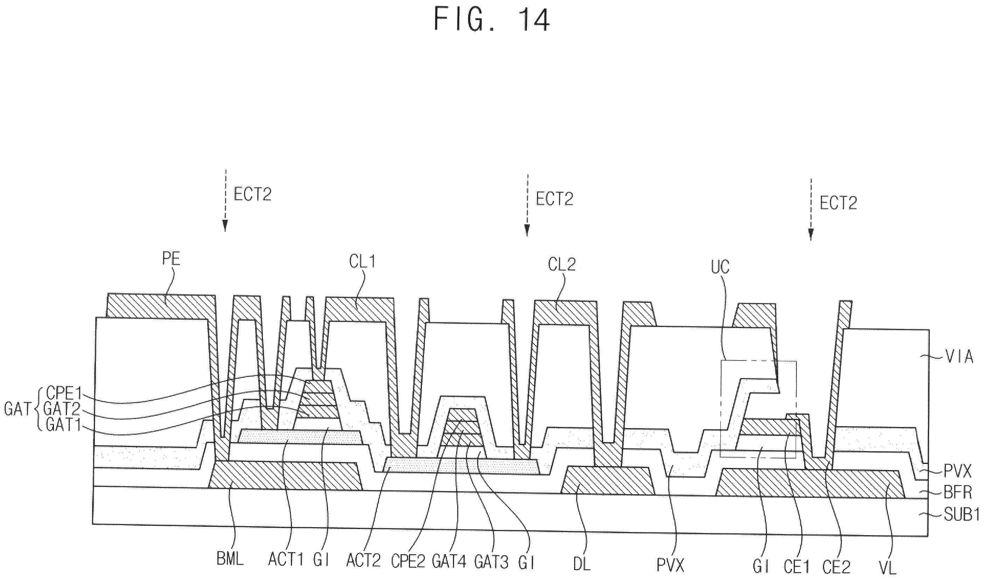

Referring to Figure 14, the preliminary second connecting electrode CE2' may be patterned. In an embodiment, the preliminary second connecting electrode CE2' may be etched by reacting with the second etchant ECT2. Accordingly, the second connecting electrode CE2 may be formed.

In an embodiment, the second etchant ECT2 may include the same material as the first etchant ECT1. In other words, the etch electrode ECE and the second connecting electrode CE2 may be formed of a metal reacting with the same etchant. For example, the etch electrode ECE may be formed of copper ("Cu"), and the second connecting electrode CE2 may include silver ("Ag") and indium tin oxide ("ITO"). In addition, the first connecting electrode CE1 may not react with the first etchant ECT1 and the second etchant ECT2. Accordingly, the first connecting electrode CE1 may remain inside the undercut shape UC.

In another embodiment, the second etchant ECT2 may include a material different from that of the first etchant ECT1. In other words, the etch electrode ECE and the second connecting electrode CE2 may react with different etchants.

Referring to Figures 15 and 16, the pixel defining layer PDL may be formed on the second connecting electrode CE2. The opening may be formed in the pixel defining layer PDL, and the emission layer EL may be formed on the pixel defining layer PDL. The emission layer EL may be formed on the entire surface of the lower structure LRS and may be cut off by the undercut shape UC.

As shown in Figure 16, the emission layer EL may be formed on the second connecting electrode CE2. In an embodiment, the emission layer EL may be deposited at a first angle DG1.

Referring to Figures 17 and 18, the common electrode CTE may be formed on the emission layer EL. The common electrode CTE may be formed on the entire surface of the lower structure LRS and may be cut off by the undercut shape UC.

As shown in Figure 18, the common electrode CTE may be formed on the emission layer EL. In an embodiment, the common electrode CTE may be deposited at a second angle DG2. For example, the first angle DG1 may be greater than the second angle DG2. Accordingly, the common electrode CTE may cover a side surface of the emission layer EL in the undercut shape UC. In addition, the common electrode CTE may contact a side surface of the second connecting electrode CE2 and an upper surface of the first connecting electrode CE1. Accordingly, the common electrode CTE may be electrically connected to the voltage line VL.

The display device DD may include the voltage line VL, the first connecting electrode CE1, the second connecting electrode CE2, and the common electrode CTE. The common electrode CTE may be electrically connected to the voltage line VL through at least one of the first connecting electrode CE1 and the second connecting electrode CE2. Accordingly, a voltage drop of the common voltage ELVSS provided to the common electrode CTE may be prevented.

In addition, the undercut shape UC in which the first connecting electrode CE1 is disposed may be formed in the passivation layer PVX overlapping the voltage line VL. The undercut shape UC may be formed by removing the etch electrode ECE, and the etch electrode ECE may be etched with the same etchant that etches the pixel electrode PE. Accordingly, the economic efficiency of the process of forming the undercut shape UC may be improved.

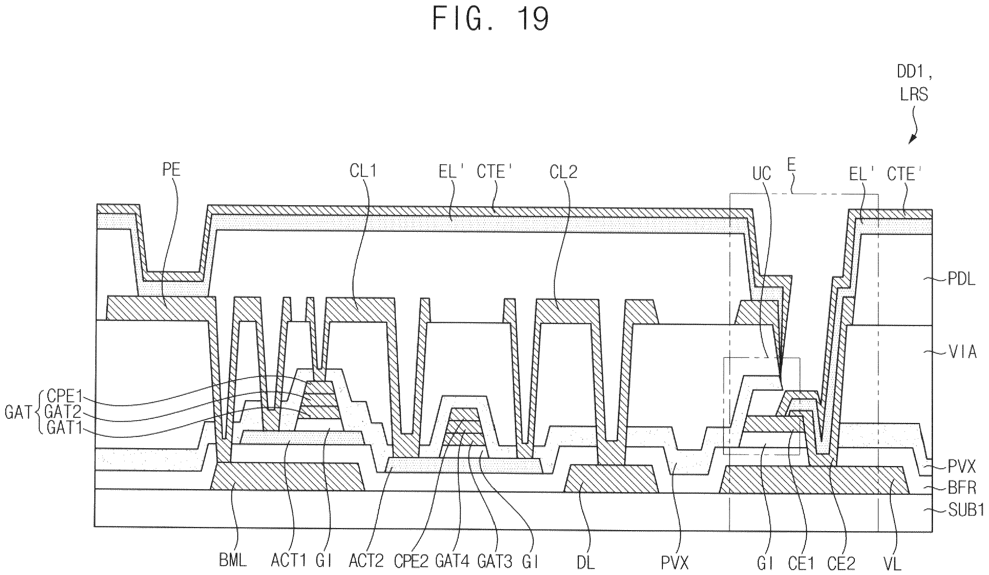

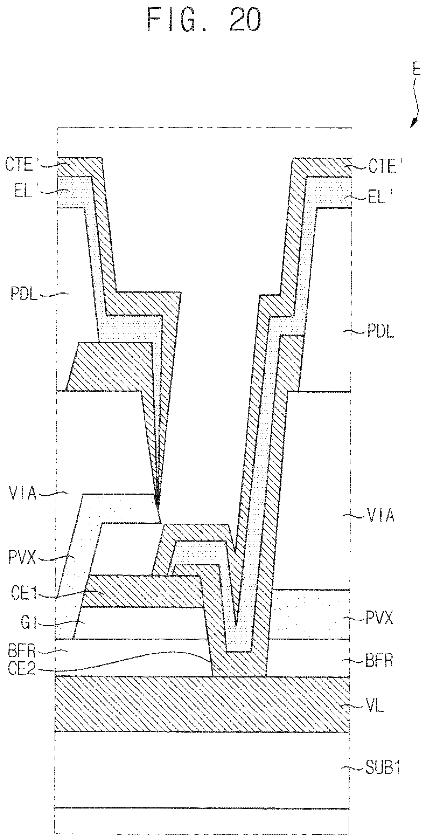

Figure 19 is a cross-sectional view illustrating a display device according to another embodiment of the present invention. Figure 20 is an enlarged view of an area E of Figure 19.

Referring to Figure 19, a display device DD1 according to another embodiment may include an emission layer EL' and a common electrode CTE'. However, the display device DD1 may be substantially the same as the display device DD described with reference to Figure 5 except for the emission layer EL' and the common electrode CTE'.

Referring to Figure 20, the emission layer EL' may be formed on the entire surface of the lower structure LRS and may be cut off by the undercut shape UC. Inside the undercut shape UC, the emission layer EL' may cover a side surface of the second connecting electrode CE2. For example, the deposition angle of the emission layer EL' may be reduced. Accordingly, the emission layer EL' may contact a side surface of the second connecting electrode CE2 and an upper surface of the second connecting electrode CE2.

The common electrode CTE' may be formed on the emission layer EL'. The common electrode CTE' may be formed on the entire surface of the lower structure LRS and may be cut off by the undercut shape UC. Inside the undercut shape UC, the common electrode CTE' may contact the upper surface of the emission layer EL', the side surface of the emission layer EL', and the upper surface of the first connecting electrode CE1.

In the above, the present invention has been described with reference to exemplary embodiments, but those of ordinary skill in the art will understand that various modifications and changes can be made to the present invention without departing from the spirit and scope of the present invention as set forth in the claims below.

### [Industrial Applicability]

The present invention can be applied to display devices and electronic devices including the same. For example, the present invention can be applied to high-resolution smartphones, mobile phones, smart pads, smart watches, tablet PCs, vehicle navigation systems, televisions, computer monitors, laptops, and the like.

Although the present invention has been described above with reference to exemplary embodiments, but those of ordinary skill in the art will understand that various modifications and changes can be made to the present invention without departing from the spirit and scope of the present invention as set forth in the claims below.

## Claims

1. A display device comprising:
a voltage line disposed on a substrate;
a passivation layer disposed on the voltage line and having an undercut shape;
a first connecting electrode disposed on the voltage line and disposed inside the undercut shape;
a second connecting electrode disposed on the voltage line and electrically connecting the voltage line to the first connecting line; and
a common electrode disposed on the second connecting electrode and electrically connected to the voltage line through at least one of the first connecting electrode and the second connecting electrode.

2. The display device of claim 1, wherein the common electrode overlaps each of the first connecting electrode and the second connecting electrode and contacts each of the first connecting electrode and the second connecting electrode.

3. The display device of claim 1, wherein the common electrode does not contact the voltage line.

4. The display device of claim 1, wherein the first connecting electrode contacts the second connecting electrode.

5. The display device of claim 1, wherein the second connecting electrode contacts the voltage line, the first connecting electrode, and the common electrode.

6. The display device of claim 1, further comprising:
an emission layer cut off by the undercut shape.

7. The display device of claim 6, wherein the emission layer is disposed between the second connecting electrode and the common electrode.

8. The display device of claim 7, wherein the common electrode covers a side surface of the emission layer.

9. The display device of claim 1, further comprising:
a data line disposed in a same layer as the voltage line;
a first gate electrode disposed in a same layer as the first connecting electrode;
a capping electrode disposed on the first gate electrode; and
a pixel electrode disposed in a same layer as the second connecting electrode.

10. A method of manufacturing a display device, the method comprising steps of:
forming a voltage line on a substrate;
forming a first connecting electrode and an etch electrode on the voltage line;
forming a preliminary passivation layer on the etch electrode to cover the etch electrode;
patterning a passivation layer to expose a side surface of the etch electrode;
removing the etch electrode so that the passivation layer has an undercut shape;
forming a second connecting electrode electrically connecting the voltage line to the first connecting electrode; and
forming a common electrode on the second connecting electrode, the common electrode is electrically connected to the voltage line through at least one of the first connecting electrode and the second connecting electrode.

11. The method of claim 10, wherein the etch electrode reacts with a first etchant through the side surface which is exposed.

12. The method of claim 11, wherein the forming the second connecting electrode is accomplished by
forming a preliminary second connecting electrode, and
etching the preliminary second connecting electrode with a second etchant, and
wherein the first etchant includes a same material as the second etchant.

13. The method of claim 12, wherein the etch electrode includes copper ("Cu"), and
wherein the preliminary second connecting electrode includes silver ("Ag") and indium tin oxide ("ITO").

14. The method of claim 10, wherein the first connecting electrode includes titanium ("Ti").

15. The method of claim 10, further comprising steps of:
forming a data line together with the voltage line on the substrate;
forming a first gate electrode together with the first connecting electrode; and
forming a capping electrode on the first gate electrode,
wherein the passivation layer exposes an upper surface of the capping electrode.

16. The method of claim 15, wherein the etch electrode reacts with a first etchant through the side surface which is exposed,
wherein the second connecting electrode reacts with a second etchant, and
wherein the capping electrode does not react with the first etchant and the second etchant.

17. The method of claim 16, wherein the first gate electrode includes titanium,
wherein the etch electrode includes copper, and
wherein the capping electrode includes titanium.

18. The method of claim 16, wherein the first gate electrode includes titanium,
wherein the etch electrode includes copper, and
wherein the capping electrode includes indium tin oxide.

19. The method of claim 10, further comprising a step of:
forming an emission layer to be cut off by the undercut shape.

20. The method of claim 19, wherein a first angle at which the emission layer is deposited is greater than a second angle at which the common electrode is deposited.
